# FASCICULE DE BREVET EUROPEEN

(11) **EP 3 080 917 B1**
(45) Date de publication et mention de la délivrance du brevet: **25.05.2022**
(21) Numéro de dépôt: 14812444.9
(22) Date de dépôt: 10.12.2014
(51) Int. Cl.: H04B 1/034, H04B 15/02

(54) **DISPOSITIF DE TÉLÉCOMMANDE À DISTANCE POUR VÉHICULE AUTOMOBILE**
FERNSTEUERUNGSVORRICHTUNG FÜR EIN KRAFTFAHRZEUG
REMOTE-CONTROL DEVICE FOR A MOTOR VEHICLE

(30) Priorité: 11.12.2013 FR 1302910
(43) Date de publication de la demande: 19.10.2016
(73) Titulaire: Valeo Comfort and Driving Assistance, 94046 Créteil Cedex (FR)
(72) Inventeur: DRUAULT, Eric, F-93000 Créteil Cedex (FR)
(86) Numéro de dépôt international: PCT/EP2014/077239
(87) Numéro de publication internationale: WO 2015/086685

(56) Documents cités:
- CN-Y- 2 565 188
- US-B1- 6 628 107

## Description

### DOMAINE TECHNIQUE DE L'INVENTION

La présente invention concerne un ensemble électronique pour dispositif de télécommande à distance pour véhicule automobile.

Elle trouve une application particulière mais non limitative dans le domaine des dispositifs de télécommande à distance.

### ARRIÈRE-PLAN TECHNOLOGIQUE DE L'INVENTION

Dans le domaine de commande à distance d'un véhicule automobile, un dispositif de télécommande à distance permet d'exécuter une fonction basique telle que le verrouillage/déverrouillage à distance du véhicule automobile qui se fait pour une portée de l'ordre de 50 mètres environ. Cependant, des fonctions plus sophistiquées sont maintenant exécutées via ledit dispositif de télécommande, telles que des fonctions de confort (préchauffage à distance du véhicule) ou encore des fonctions d'affichage du statut du véhicule sur un écran du dispositif de télécommande à distance. Ces fonctions nécessitent une grande portée de communication. A cet effet, l'ensemble électronique pour le dispositif de télécommande comprend un émetteur/récepteur et un amplificateur de fréquence qui permettent d'établir la communication entre ledit dispositif de télécommande et le véhicule automobile et d'obtenir ainsi une portée de l'ordre de 500 mètres. En outre, l'ensemble électronique comprend une source de courant qui est une pile bouton pour alimenter l'ensemble de ces composants électroniques. La pile bouton délivre une tension de l'ordre de 3V. L'avantage d'une pile bouton est qu'elle est à faible encombrement par rapport à une pile bâton, ce qui est intéressant pour le dispositif de télécommande dans laquelle la place est limitée.

Cependant, un inconvénient de cet état de la technique réside dans le fait que l'amplificateur de fréquence consomme beaucoup de courant, de l'ordre de 100mA, lorsqu'il communique avec le véhicule automobile et notamment à chaque émission radiofréquence. La pile bouton qui comporte une résistance interne subit une chute de tension (appelée en anglais « drop voltage ») très importante, de l'ordre de 1V, lors du passage de courant important nécessaire à l'amplificateur de fréquence. En conséquence, la pile bouton se décharge très rapidement et ne fournit ainsi plus que 2V. Cette décharge trop rapide et cette chute de tension importante entraînent ainsi des dysfonctionnements du dispositif de télécommande à distance comprenant ledit ensemble électronique tel que le passage en dessous d'une tension de fonctionnement et en conséquence une diminution de la portée de communication dudit dispositif de télécommande, voire même sa réinitialisation avec perte d'informations. On notera que la tension de fonctionnement limite d'un tel dispositif de télécommande à distance se situe aux alentours de 2V.

Les documents US7605689 et US6628107 sont des exemples de l'art antérieur associé a la présente invention.

Dans ce contexte, la présente invention vise à résoudre l'inconvénient précédemment mentionné.

### DESCRIPTION GENERALE DE L'INVENTION

A cette fin l'invention propose un ensemble électronique pour dispositif de télécommande à distance pour véhicule automobile selon la revendication 1.

### BREVE DESCRIPTION DES FIGURES

L'invention et ses différentes applications seront mieux comprises à la lecture de la description qui suit et à l'examen des figures qui l'accompagnent.
- la figure 1 représente un schéma d'un ensemble électronique pour dispositif de télécommande à distance selon l'invention ;
- la figure 2 représente un schéma du dispositif de télécommande à distance adapté pour communiquer avec un véhicule automobile, ledit dispositif de télécommande comprenant l'ensemble électronique de la figure 1.

### DESCRIPTION DE MODES DE REALISATION DE L'INVENTION

Les éléments identiques, par structure ou par fonction, apparaissant sur différentes figures conservent, sauf précision contraire, les mêmes références.

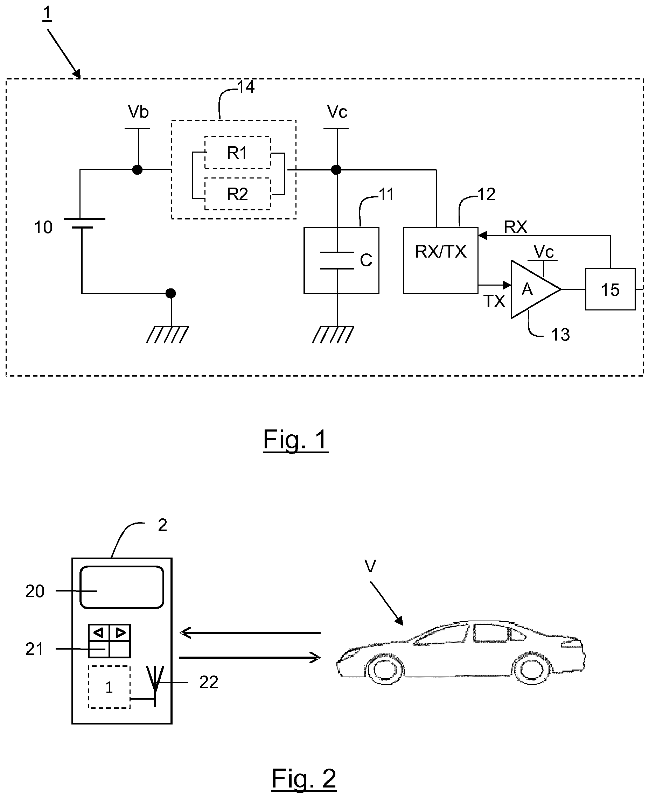

L'ensemble électronique 1 pour dispositif de télécommande à distance 2 est décrit en référence à la figure 1.

Tel qu'illustré à la figure 1, selon un mode de réalisation non limitatif, l'ensemble électronique 1 comporte :
- une source de courant 10 ;
- un bloc de supercapacité(s) 11, ledit bloc de supercapacité(s) 11 étant disposé en parallèle de la source de courant 10 ;
- un émetteur/récepteur 12 connecté audit bloc de supercapacité(s) 11 ; et
- un étage amplificateur de fréquence 13 connecté audit émetteur/récepteur 12.

La source de courant 10 est dans un exemple non limitatif une pile bouton. Dans un exemple non limitatif, la source de courant 10 fournit une tension Vb de 3V et comporte une résistance interne d'environ 10Ω pour une température extérieure de 25°C et d'environ 50 Ω à -20°C.

Dans la suite de la description, on prendra l'exemple non limitatif de la pile bouton.

La pile bouton 10 est connectée en amont du bloc de supercapacité(s) 11. Elle va permettre de recharger ledit bloc 11.

Le bloc de supercapacité(s) 11 comprend une ou plusieurs supercapacités C. Dans un exemple de réalisation non limitatif illustré à la figure 1, le bloc de supercapacité(s) 11 comprend une seule supercapacité C. Le fait d'avoir une unique supercapacité C permet de réduire l'espace utilisé. Dans un mode de réalisation non limitatif, cette supercapacité est de l'ordre d'une centaine de milli-farads pour permettre, d'une part, de délivrer un fort courant d'alimentation de l'ordre de 100mA à l'ensemble électronique 1, et d'autre part, d'avoir un bloc de supercapacité(s) 11 assez petit pour s'insérer dans le faible espace du dispositif de télécommande à distance 2. Cet ordre de valeur d'une centaine de mF évite également une décharge trop rapide de la supercapacité C. Les supercapacités de cet ordre comportent une résistance interne de l'ordre de 0,1Ω.

Ainsi, dans un exemple de réalisation non limitatif, la valeur de la supercapacité C (ou des supercapacités prises dans leur ensemble) est supérieure ou égale à 150mF. Cette valeur limite inférieure permet de prendre en compte un protocole de communication particulier utilisé entre le dispositif de télécommande 2 et le véhicule automobile V (notamment la durée d'émission de trames radiofréquences dites « RF », la période de répétition des émissions), et l'autonomie du dispositif de télécommande à distance 2. Ce protocole particulier est utilisé pour les commandes à distance telles que dans un exemple non limitatif l'affichage du statut du véhicule automobile V. Les caractéristiques du protocole de communication particulier décrit dans un exemple non limitatif sont les suivantes.

La durée d'émission de trames radiofréquences se situe entre 26 ms et 55ms tandis que la durée d'une réception de trames radiofréquences se situe entre 40ms et 140ms. En ce qui concerne la répétition des émissions, la durée entre les deux premières émissions RF est de 75ms ; la durée entre la deuxième et la troisième émission est de 45ms.

Cette séquence (trois émissions RF espacées de 75ms et 45ms) se répète plusieurs fois dans l'application en fonction des commandes de l'utilisateur. L'autonomie du dispositif 2 est de deux ans selon un profil d'utilisation défini en température (15% du temps à 60°C, 75% du temps à 25°C et 10% du temps à -10°C).

On notera que plus l'émission d'une trame est courte, moins on a besoin d'énergie et plus on peut baisser la valeur des supercapacités. Ainsi, pour certains protocoles de communication avec des trames plus courtes, on peut avoir une valeur limite inférieure de 10mF pour la supercapcaité C du bloc 11 (ou les supercapacités C du bloc 11 prises dans leur ensemble). Par ailleurs, on notera que la valeur limite supérieure de la supercapacité C (ou des supercapacités prises dans leur ensemble) est déterminée notamment par l'espace disponible dans le dispositif de télécommande à distance 2.

Dans un exemple non limitatif, la valeur de la supercapacité C est de 220mF et sa taille est de l'ordre de 2cm sur 1cm. Elle peut supporter des courants limites de l'ordre de 10A.

L'émetteur/récepteur 12 est connecté en aval du bloc de supercapacité(s) 11 et en amont au bloc amplificateur 12. Le bloc de supercapacité(s) 11 permet ainsi d'alimenter l'émetteur/récepteur 12 en courant.

Le dispositif de télécommande à distance 2 (également appelé système mains libres) est représenté à la figure 2. Dans un mode de réalisation non limitatif, il comporte :
- un écran 20 pour afficher des informations provenant notamment du véhicule automobile V ;
- un dispositif de commandes utilisateur 21 ;
- l'ensemble électronique 1 ; et
- une antenne 22.

Lorsqu'un utilisateur lance une commande, dans un exemple non limitatif une commande de préchauffage du véhicule automobile V ou une commande d'affichage du statut de véhicule automobile V, il le fait à partir du dispositif de commandes utilisateur 21 du dispositif de télécommande à distance 2. A ce moment, un protocole de communication est déclenché entre le dispositif de télécommande à distance 2 et le véhicule automobile V. Ce protocole de communication comprend l'émission d'une pluralité de trames radiofréquence dit « RF » à partir du dispositif de télécommande 2, et la réception d'une pluralité de trames RF par ledit dispositif 2, trames provenant du véhicule automobile V (plus particulièrement d'un émetteur/récepteur dudit véhicule).

Cette émission/réception se fait au moyen de l'émetteur/récepteur 12 et de l'étage amplificateur de fréquence 13 qui permet d'augmenter la puissance d'émission RF et ainsi d'envoyer via l'antenne 22 une commande sur une distance d'environ 500 mètres par rapport au véhicule V. Un commutateur 15 connecté en aval de l'étage amplificateur 13 et en amont de l'antenne 22 permet de positionner ladite antenne 22 en mode réception ou en mode émission. Dans un exemple non limitatif, l'antenne 22 émet autour de 434Mhz.

L'émission d'une série de trames RF (appelée « burst » en anglais) nécessite un courant d'alimentation, de l'ordre de 100mA, car l'étage amplificateur 13 nécessite l'utilisation d'un fort courant. Un courant fort de cet ordre permet ainsi une émission RF longue distance.

Lors de l'émission d'une série de trames RF, le bloc de supercapacité(s) 11 se décharge afin de fournir le courant nécessaire (100mA) pour ladite émission à l'émetteur/récepteur 12 ainsi qu'à l'étage amplificateur 13.

Il existe une chute de tension due à la résistance interne de la supercapacité C, mais cette chute de tension est très faible (de l'ordre de 100mV) comparé à la tension Vb de 3V de l'ensemble électronique 1. La pile bouton 10 ne subit plus elle-même de chute de tension de sorte qu'elle n'altère plus la tension Vb.

Ainsi, grâce au bloc de supercapacité(s) 11, l'effet négatif de la pile bouton 10 est masqué. On s'affranchit de la résistance interne de la pile bouton 10. Autrement dit, on s'affranchit ainsi d'une chute de tension pouvant aller de 1V (à 25°C) jusqu'à à 3V lorsque le pile est à froid (à -20°C). On s'affranchit également de l'effet du vieillissement de la pile bouton 10 dont la résistance interne augmente avec le vieillissement.

Le dispositif de télécommande à distance 2 peut fonctionner quelques secondes sans la pile bouton puisque c'est maintenant le bloc de supercapacité(s) 11 qui fournit le courant nécessaire à son fonctionnement. Ainsi, dans le cas où il existe une perte de contact de la pile bouton, qui peut arriver par exemple lorsque l'utilisateur fait tomber le dispositif de télécommande 2 par inadvertance, l'ensemble électronique 1 ne voit pas de microcoupure de tension. Il n'y a donc pas de réinitialisation du dispositif de télécommande 2. En conséquence, il n'y a pas de perte d'informations lors de l'écriture d'informations dans une mémoire réinscriptible du dispositif 2, lesdites informations étant fournies à l'utilisateur du véhicule V.

On notera que la durée d'émission RF détermine le courant consommé. Plus les échanges entre le dispositif de télécommande 2 et le véhicule sont longs, plus l'appel de courant d'alimentation dure longtemps, et en conséquence plus la décharge de la supercapacité C du bloc 11 dure longtemps pour fournir cet appel de courant.

Le bloc de supercapacité(s) 11 est ainsi dimensionné pour, d'une part, que la ou les supercapacités ne se déchargent pas trop rapidement, et, d'autre part, répondre à la contrainte dimensionnelle du dispositif de télécommande à distance 2 qui ne peut inclure ni une supercapacité de grande taille, ni une antenne RF 22 de grande taille.

En même temps que la supercapacité C se décharge, la pile bouton 10 qui est connectée en parallèle de la supercapacité C recharge la supercapacité C à sa propre tension, à savoir 3V (lorsque la pile bouton est chargée au maximum) jusqu'à ce qu'il y ait un équilibre des tensions entre ladite pile bouton 10 et le bloc de supercapacité(s) 11.

On rappelle que la charge de la pile bouton 10 se fait moins rapidement que la décharge de la supercapacité C et que la tension aux bornes de la pile bouton diminue au fur et à mesure que ladite pile vieillit.

Ainsi, la pile bouton 10 compense la décharge du bloc de supercapacité(s) 11, chute de tension due à un appel de courant généré par l'envoi d'une commande à distance au véhicule automobile V par exemple.

Cette charge par la pile bouton 10 est ainsi cyclique puisqu'elle s'exécute à chaque fois qu'il existe un appel de courant pour une émission d'une série de trame RF.

On notera que lors du démarrage ou initialisation du dispositif de télécommande 2, le même protocole de communication est utilisé pour remonter notamment le statut du véhicule V à l'utilisateur sur l'écran 20 du dispositif de télécommande 2, et le même phénomène de décharge de la supercapacité C/charge par la source de courant 10 s'opère. Dans des exemples non limitatifs, le statut du véhicule comprend :
- un indicateur pour indiquer si la climatisation est allumée/éteinte ;
- des compteurs préprogrammés pour allumer/éteindre la climatisation ;
- la date ;
- un indicateur pour indiquer à l'utilisateur s'il doit faire le plein ; et
- un indicateur de charge de la batterie du véhicule automobile V.

D'autres informations peuvent être également indiquées sur l'écran 20 du dispositif de télécommande 2, telle que dans un exemple non limitatif, l'information que le véhicule se situe dans la portée de communication du dispositif 2.

Dans le mode de réalisation illustré sur la figure 1, l'ensemble électronique 1 comprend en outre un bloc de protection 14 (représenté en traits discontinus) du bloc de supercapacité(s) 11 pour limiter un appel de courant depuis le bloc de supercapacité(s) 11 vers la pile bouton 10. On notera que dans ce cas, la tension utile pour alimenter l'ensemble électronique 1 est la tension Vc indiquée sur la figure 1 (au lieu de Vb dans le cas où il n'y a pas de bloc de protection 14). Ledit bloc 14 comprend deux résistances R1 et R2 en parallèle. Cela permet d'avoir des résistances faibles qui supportent des courant de décharge de l'ordre de 1 à 3A et qui prennent moins de place qu'une unique résistance. Dans un exemple non limitatif, les résistances R1 et R2 sont égales à 2,7Ω.

Ce bloc de protection 14 permet de limiter un appel de courant depuis le bloc de supercapacité(s) 11 vers la pile bouton 10 lorsque les polarités de la pile bouton 10 sont inversées. Ce cas peut arriver lorsque l'utilisateur change la pile bouton 10 et que l'utilisateur se trompe et inverse les contacts de la pile. En effet, lorsque les polarités sont inversées, le même potentiel est appliqué sur les deux contacts de la pile bouton 10 créant un court-circuit. Si la supercapacité C est chargée à 3V, elle se décharge d'un seul coup et son potentiel se retrouve donc à 0V (dans le cas d'une conception mécanique d'une pile bouton qui impose un même potentiel lors d'une inversion). On notera que dans les autres cas, le potentiel se retrouve à -3V au lieu de 0V. Cette décharge instantanée entraîne un appel de courant supérieur à 10A ce qui risque d'endommager la supercapacité C (le courant limite supporté par la supercapacité C étant de l'ordre de 10A), ou au minimum de la faire vieillir trop rapidement.

Grâce à au bloc de protection 14, on limite l'appel de courant à 3A car les résistances R1, R2 limitent la vitesse de décharge de la supercapacité C vers la pile bouton 10, lorsque le bloc de supercapacité(s) 11 est chargé à 3V. Ainsi, on protège la supercapacité C contre l'endommagement et/ou le vieillissement et de fait, la valeur de la supercapacité ne risque pas de diminuer. Il n'y a pas de risque de diminution de réserve d'énergie et donc il n'y a pas de risque que le dispositif de télécommande à distance 2 soit moins efficace (diminution de sa portée de communication) ou encore ne fonctionne plus.

Bien entendu la description de l'invention n'est pas limitée à l'application, aux modes de réalisation et aux exemples décrits ci-dessus. Ainsi, dans un autre mode de réalisation non limitatif, l'ensemble électronique 1 comporte ladite antenne 22.

Ainsi, ladite antenne 22 peut émettre à d'autres fréquences, telles que par exemple à des bandes fréquences autour de 315Mhz (utilisables au Japon et aux Etats-Unis) ou encore autour de 868MHz ou 915Mhz (utilisables en Europe ou aux Etats-Unis).

Ainsi, l'invention décrite présente notamment les avantages suivants :
- elle permet d'augmenter l'autonomie du dispositif de télécommande à distance en s'affranchissant du vieillissement de la source de courant 10 et du problème de la pile à froid (problème des basses températures);
- elle permet d'avoir un dimensionnement réduit de l'ensemble électronique 1 en utilisant une ou plusieurs supercapacités ;
- elle permet de ne pas être en dessous d'une tension de fonctionnement du dispositif de télécommande à distance 2 ;
- elle permet de ne pas dégrader les performances (autonomie, portée de communication) du dispositif de télécommande à distance 2 ;
- elle permet d'éviter d'endommager le bloc de supercapacité(s) 11 grâce à l'utilisation du bloc de protection 14 qui est adapté pour limiter un appel de courant.

## Revendications

1. Ensemble électronique (1) pour dispositif de télécommande à distance (2) pour véhicule automobile (V) selon lequel ledit ensemble électronique (1) comportant :
- une source de courant (10) ;
- un bloc de supercapacité(s) (11), ledit bloc de supercapacité(s) (11) étant disposé en parallèle de la source de courant (10) ;
- un émetteur/récepteur (12) connecté audit bloc de supercapacité(s) (11) ; et
- un étage amplificateur de fréquence (13) connecté audit émetteur/récepteur (12) ;
**caractérisé en ce qu'**il comporte un bloc de protection (14) du bloc de supercapacité(s) (11) pour limiter un appel de courant depuis le bloc de supercapacité(s) (11) vers la source de courant (10), ledit bloc de de protection (14) étant disposé en série avec la source de courant (10) et comprenant deux résistances (R1, R2) en parallèle.

2. Ensemble électronique (1) selon la revendication 1 ou la revendication 2, selon lequel le bloc de supercapacité(s) (11) comporte une valeur supérieure ou égale à dix milli-farads.

3. Ensemble électronique (1) selon l'une quelconque des revendications précédentes, selon lequel le bloc de supercapacité(s) (11) comporte une valeur supérieure ou égale à cent cinquante millifarads.

4. Ensemble électronique (1) selon l'une quelconque des revendications précédentes, selon lequel le bloc de supercapacité(s) (11) comporte une unique supercapacité (C) d'une valeur de deux cent vingt milli-farads.

5. Dispositif de télécommande à distance (2) pour véhicule automobile (V) selon lequel ledit dispositif de télécommande (1) comporte l'ensemble électronique (1) selon l'une quelconque des revendications précédentes, un dispositif de commandes utilisateur (21) et une antenne (22).

## Patentansprüche

1. Elektronische Einheit (1) für eine Fernsteuerungsvorrichtung (2) für ein Kraftfahrzeug (V), wobei die elektronische Einheit (1) aufweist:
- eine Stromquelle (10);
- einen Block von Superkapazität(en) (11), wobei der Block von Superkapazität(en) (11) parallel zur Stromquelle (10) angeordnet ist;
- einen Sender/Empfänger (12), der mit dem Block von Superkapazität(en) (11) verbunden ist; und
- eine Frequenzverstärkerstufe (13), die mit dem Sender/Empfänger (12) verbunden ist;
**dadurch gekennzeichnet, dass** sie einen Schutzblock (14) des Blocks von Superkapazität(en)s (11) aufweist, um einen Stromstoß vom Block von Superkapazität(en) (11) zur Stromquelle (10) zu begrenzen, wobei der Schutzblock (14) in Reihe mit der Stromquelle (10) angeordnet ist und zwei parallelgeschaltete Widerstände (R1, R2) enthält.

2. Elektronische Einheit (1) nach Anspruch 1 oder Anspruch 2, wobei der Block von Superkapazität(en) (11) einen Wert höher als oder gleich zehn Millifarad aufweist.

3. Elektronische Einheit (1) nach einem der vorhergehenden Ansprüche, wobei der Block von Superkapazität(en) (11) einen Wert höher als oder gleich einhundertfünfzig Millifarad aufweist.

4. Elektronische Einheit (1) nach einem der vorhergehenden Ansprüche, wobei der Block von Superkapazität(en) (11) einen einzigen Superkapazität (C) eines Werts von zweihundertzwanzig Millifarad aufweist.

5. Fernsteuerungsvorrichtung (2) für ein Kraftfahrzeug (V), wobei die Fernsteuerungsvorrichtung (1) die elektronische Einheit (1) nach einem der vorhergehenden Ansprüche, eine Benutzersteuerungsvorrichtung (21) und eine Antenne (22) aufweist.

## Claims

1. Electronic assembly (1) for a remote-control device (2) for a motor vehicle (V) in which said electronic assembly (1) includes:
- a current source (10);
- a block of one or more supercapacitors (11), said block of one or more supercapacitors (11) being arranged in parallel with the current source (10) ;
- a transceiver (12) connected to said block of one or more supercapacitors (11); and
- a frequency amplifier stage (13) connected to said transceiver (12);
**characterized in that** it includes a protection block (14) for the block of one or more supercapacitors (11) in order to limit a current draw from the block of one or more supercapacitors (11) to the current source (10), said protection block (14) being arranged in series with the current source (10) and comprising two resistors (R1, R2) in parallel.

2. Electronic assembly (1) according to Claim 1 or Claim 2, wherein the block of one or more supercapacitors (11) has a value greater than or equal to ten millifarads.

3. Electronic assembly (1) according to either one of the preceding claims, wherein the block of one or more supercapacitors (11) has a value greater than or equal to one hundred and fifty millifarads.

4. Electronic assembly (1) according to any one of the preceding claims, wherein the block of one or more supercapacitors (11) includes a single supercapacitor (C) having a value of two hundred and twenty millifarads.

5. Remote-control device (2) for a motor vehicle (V) wherein said remote-control device (1) includes the electronic assembly (1) according to any one of the preceding claims, a user control device (21) and an antenna (22) .
